# EUROPEAN PATENT SPECIFICATION

(11) **EP 4 178 317 B1**
(45) Date of publication and mention of the grant of the patent: **04.11.2026**
(21) Application number: 22202273.3
(22) Date of filing: 20.07.2016
(51) Int. Cl.: H05B 33/12, H05B 33/10, H05B 33/20, H05B 33/14, H05B 33/18, H10H 29/37, H10H 29/39, H10H 29/855, H10P 72/70, H10W 72/00, H10W 90/00, H10W 70/09, G09G 3/32, H10H 29/01, H10H 29/851

(54) **DISPLAY APPARATUS**
ANZEIGEVORRICHTUNG
DISPOSITIF D'AFFICHAGE

(30) Priority: 23.07.2015 US 201562196282 P; 15.12.2015 US 201562267770 P
(43) Date of publication of application: 10.05.2023
(62) Document number(s) of the earlier application(s) in accordance with Art. 76 EPC: 20203976.4 / 3 790 361; 16828068.3 / 3 328 162
(73) Proprietor: Seoul Semiconductor Co., Ltd., Gyeonggi-do 15429 (KR)
(72) Inventor: TAKEYA, Motonobu, 15429 Ansan-si (KR); KIM, Young Hyun, 15429 Ansan-si (KR)
(74) Representative: Stolmár & Partner Patentanwälte PartG mbB

(56) References cited:
- KR-A- 20130 092 896
- KR-B1- 101 476 207
- US-A1- 2007 195 044
- US-A1- 2015 137 153

## Description

### [Technical Field]

Exemplary embodiments of the present disclosure relate to a display apparatus and a method of manufacturing the same, and more particularly, to a display apparatus using micro-light emitting diodes and a method of manufacturing the same.

### [Background Art]

A light emitting diode refers to an inorganic semiconductor device configured to emit light through recombination of electrons and holes and has been used in various fields including displays, automobile lamps, general lighting, and the like. Since the light emitting diode has various advantages such as long lifespan, low power consumption, and rapid response, it is expected that a light emitting device using the light emitting diode will replace existing light sources.

Recently, smart TVs or monitors realize colors using a thin film transistor liquid crystal display (TFT LCD) panel and tend to use light emitting diodes (LEDs) as a light source for a backlight unit for color realization. In addition, a display apparatus is often manufactured using organic light emitting diodes (OLEDs). However, for a TFT-LCD, since one LED is used as a light source for many pixels, a light source of a backlight unit is always turned on. Accordingly, the TFT-LCD suffers from constant power consumption regardless of brightness on a displayed screen. In order to compensate for this problem, some display apparatuses are configured to divide a screen into several regions so as to allow control of brightness in these regions. However, since several to dozens of thousands of pixels are used as a unit for division of the screen, it is difficult to achieve accurate regulation of brightness while reducing power consumption. On the other hand, although an OLED has continuously reduced power consumption through development of technology, the OLED still has much higher power consumption than LEDs formed of inorganic semiconductors and thus has low efficiency.

In addition, a PM drive type OLED can suffer from deterioration in response speed upon pulse amplitude modulation (PAM) of the OLED having large capacitance, and can suffer from deterioration in lifespan upon high current driving through pulse width modulation (PWM) for realizing a low duty ratio. Moreover, an AM driving type OLED requires connection of TFTs for each pixel, thereby causing increase in manufacturing costs and non-uniform brightness according to characteristics of TFTs.

### [Prior Document]

Japanese Patent Laid-open Publication No. 2015-500562 (January 5, 2015).

Document KR 101 476 207 B1 discloses a display device using a semiconductor light emitting element including a plurality of pixel electrodes placed on a substrate, a plurality of semiconductor light emitting elements composing individual pixels and connected to a first electrode, a plurality of common electrodes connected to a second electrode of the semiconductor light emitting elements, and a phosphor layer placed on the semiconductor light emitting elements.

### [ Disclosure]

### [Technical Problem]

Exemplary embodiments provide a display apparatus using micro-light emitting diodes providing low power consumption to be applicable to a wearable apparatus, a smartphone or a TV, and a method of manufacturing the same.

Exemplary embodiments provide a display apparatus providing low power consumption and enabling accurate regulation of brightness and a method of manufacturing the same.

### [Technical Solution]

According to the invention, there is disclosed a display device as recited in claim 1.

In accordance with one aspect of the present disclosure, a display apparatus includes: a first substrate including a light emitting diode part including a plurality of light emitting diodes regularly arranged on the first substrate; and a second substrate including a TFT panel unit including a plurality of TFTs driving the light emitting diodes, wherein the first substrate and the second substrate are coupled to each other so as to face each other such that the light emitting diodes are electrically connected to the TFTs, respectively.

The light emitting diode part may include: a support substrate; a plurality of blue light emitting diodes arranged on an upper surface of the support substrate; a plurality of green light emitting diodes arranged on the upper surface of the support substrate to be placed adjacent the plurality of blue light emitting diodes; and a plurality of red light emitting diodes arranged on the upper surface of the support substrate to be placed adjacent either the plurality of blue light emitting diodes or the plurality of green light emitting diodes.

Each of the plurality of blue light emitting diodes, the plurality of green light emitting diodes and the plurality of red light emitting diodes may include an n-type semiconductor layer; a p-type semiconductor layer; an active layer interposed between the n-type semiconductor layer and the p-type semiconductor layer; an n-type electrode coupled to the n-type semiconductor layer; a p-type electrode coupled to the p-type semiconductor layer; and a wall surrounding the p-type electrode.

The light emitting diode part may further include a first bonding portion bonding the plurality of blue light emitting diodes to the support substrate; a second bonding portion bonding the plurality of green light emitting diodes to the support substrate; and a third bonding portion bonding the plurality of red light emitting diodes to the support substrate, and the first to third bonding portions may have different melting points.

The display apparatus may further include an anisotropic conductive film electrically connecting the light emitting diode part to the TFT panel unit.

The plurality of light emitting diodes may include blue light emitting diodes emitting blue light, and the display apparatus may further include a wavelength conversion part including at least one of a blue light portion emitting the blue light, a green light portion emitting green light through conversion of the blue light into the green light, and a red light portion emitting red light through conversion of the blue light into the red light.

The plurality of light emitting diodes may include blue light emitting diodes emitting blue light and red light emitting diodes emitting red light, and the display apparatus may further include a wavelength conversion part including at least one of a blue light portion emitting the blue light, a green light portion emitting green light through conversion of the blue light into the green light, and a red light portion emitting the red light.

The wavelength conversion part may be formed on a third substrate and the first substrate may be coupled to the third substrate to allow wavelength conversion of light emitted from the plurality of light emitting diodes. The green light portion and the red light portion may include phosphors. Specifically, the green light portion may include nitride phosphors and the red light portion may include nitride or fluoride phosphors (KSF).

At least one of the first to third substrates may be a transparent substrate or an opaque flexible substrate.

The plurality of light emitting diodes may include blue light emitting diodes emitting blue light, and the display apparatus may further include a white phosphor portion converting blue light emitted from the blue light emitting diodes into white light; and a color filter including a blue light portion allowing blue light of the white light emitted through the white phosphor portion to pass therethrough, a green light portion allowing green light of the white light emitted through the white phosphor portion to pass therethrough, and a red light portion allowing red light of the white light emitted through the white phosphor portion to pass therethrough.

Each of the light emitting diodes may include an n-type semiconductor layer, a p-type semiconductor layer, and an active layer interposed between the n-type semiconductor layer and the p-type semiconductor layer, and a wall may be formed on the p-type semiconductor layer.

In accordance with a further aspect of the present disclosure, a method of manufacturing a display apparatus includes: forming a light emitting diode part such that a plurality of light emitting diodes is regularly arranged therein; and coupling the light emitting diode part to a TFT panel unit, wherein forming the light emitting diode part may include forming the plurality of light emitting diodes on a substrate to be regularly arranged thereon; transferring the plurality of light emitting diodes to a stretchable substrate; two-dimensionally enlarging the stretchable substrate such that a separation distance between the light emitting diodes is enlarged; and coupling at least one of the light emitting diodes to a support substrate, with the separation distance between the light emitting diodes enlarged by the stretchable substrate.

The separation distance between the light emitting diodes enlarged by the stretchable substrate may be twice a width of the light emitting diodes.

Coupling the light emitting diode part to the TFT panel unit may be performed using an anisotropic conductive film.

### [Advantageous Effects]

According to exemplary embodiments, the display apparatus employs micro-light emitting diodes formed of nitride semiconductors and thus can provide high efficiency and high resolution to be applicable to a wearable apparatus while reducing power consumption.

Further, the display apparatus according to the exemplary embodiments employs a stretchable substrate, thereby providing more convenience in manufacture of the display apparatus than manufacture of the display apparatus using micro-light emitting diodes.

### [Description of Drawings]

FIG. 1 is a sectional view of a display apparatus according to a first exemplary embodiment of the present disclosure, which is an embodiment of the invention.
FIG. 2 is a perspective view of a light emitting part of the display apparatus according to the first exemplary embodiment of the present disclosure.
FIG. 3 and FIG. 4 are sectional views and plan views illustrating a process of forming the light emitting diode part of the display apparatus according to the first exemplary embodiment of the present disclosure.
FIG. 5 is a sectional view of a display apparatus according to a second exemplary embodiment of the present disclosure, which is an embodiment of the invention.
FIG. 6 is a sectional view of a display apparatus according to a third exemplary embodiment of the present disclosure, which is an embodiment of the invention.
FIG. 7 is a sectional view of a display apparatus according to a fourth exemplary embodiment of the present disclosure, which is an embodiment of the invention.
FIG. 8 shows sectional views of a display apparatus according to a fifth exemplary embodiment of the present disclosure.

### [Best Mode]

Hereinafter, exemplary embodiments of the present disclosure will be described in detail with reference to the accompanying drawings.

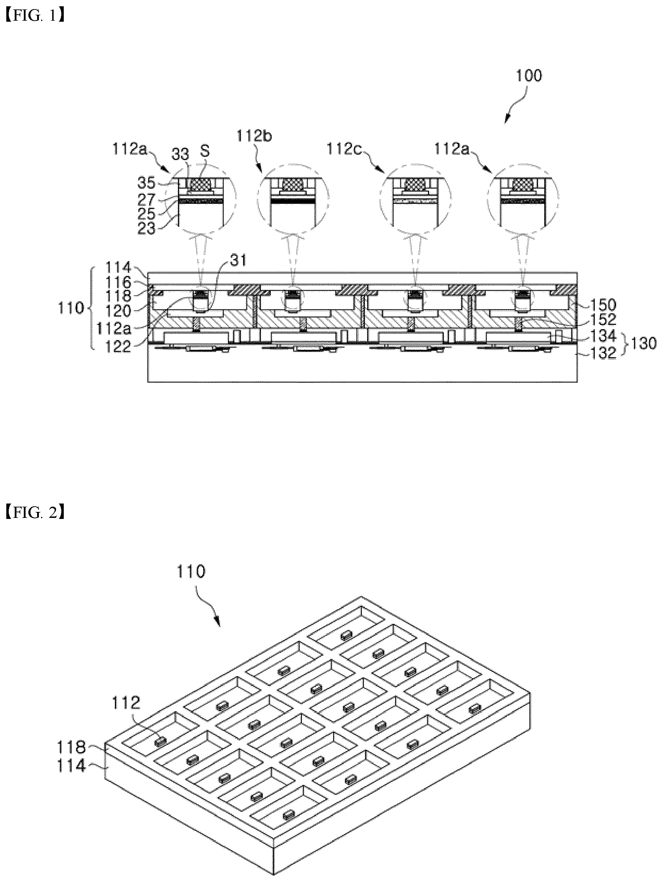

FIG. 1 is a sectional view of a display apparatus according to a first exemplary embodiment of the present disclosure, and FIG. 2 is a perspective view of a light emitting part of the display apparatus according to the first exemplary embodiment of the present disclosure.

Referring to FIG. 1, a display apparatus 100 according to the first exemplary embodiment includes a light emitting diode part 110, a TFT panel unit 130, and an anisotropic conductive film 150.

Referring to FIG. 1 and FIG. 2, the light emitting diode part 110 includes light emitting diodes 112, a support substrate 114, transparent electrodes 116, a blocking part 118, an insulation layer 120, and first connection electrodes 122.

The light emitting diode part 110 includes a plurality of light emitting diodes 112, and the plurality of light emitting diodes 112 is regularly arranged on the support substrate 114. For example, the plurality of light emitting diodes 112 may be arranged in a matrix form thereon, as shown in FIG. 2. In this exemplary embodiment, the plurality of light emitting diodes 112 includes a plurality of blue light emitting diodes 112a emitting blue light, a plurality of green light emitting diodes 112b emitting green light, and a plurality of red light emitting diodes 112c emitting red light. The plural blue light emitting diodes 112a, the plural green light emitting diodes 112b and the plural red light emitting diodes 112c are alternately arranged such that the blue light emitting diode 112a, the green light emitting diode 112b and the red light emitting diode 112c are adjacent to one another.

In this exemplary embodiment, as shown in FIG. 2, the light emitting diode part 110 allows the display apparatus 100 to be driven by power applied from an exterior power source. That is, an image can be reproduced through on-off combination of the light emitting diodes 112 in the light emitting diode part 110 without using a separate LCD. Accordingly, a region including a single light emitting diode 112 is used as a sub-pixel in the display apparatus 100. As shown in FIG. 2, in the light emitting diode part 110, one sub-pixel may have a larger size than the light emitting diode 112 disposed inside the sub-pixel.

Referring to FIG. 1 again, each of the light emitting diodes 112 includes an n-type semiconductor layer 23, an active layer 25, a p-type semiconductor layer 27, an n-type electrode 31, a p-type electrode 33, and may include a wall 35. The n-type semiconductor layer 23, the active layer 25 and the p-type semiconductor layer 27 may include Group III-V based compound semiconductors. By way of example, the n-type semiconductor layer 23, the active layer 25 and the p-type semiconductor layer 27 may include nitride semiconductors such as (Al, Ga, In)N. In other exemplary embodiments, locations of the n-type semiconductor layer 23 and the p-type semiconductor layer 27 can be interchanged.

The n-type semiconductor layer 23 may include an n-type dopant (for example, Si) and the p-type semiconductor layer 27 may include a p-type dopant (for example, Mg). The active layer 25 is interposed between the n-type semiconductor layer 23 and the p-type semiconductor layer 27. The active layer 25 may have a multi-quantum well (MQW) structure and a composition of the active layer 25 may be determined so as to emit light having a desired peak wavelength.

In addition, the light emitting structure including the n-type semiconductor layer 23, the active layer 25 and the p-type semiconductor layer 27 may be formed similar to a vertical type light emitting diode 112. In this structure, the n-type electrode 31 is formed on an outer surface of the n-type semiconductor layer 23 and the p-type electrode 33 is formed on an outer surface of the p-type semiconductor layer 27.

Further, as shown in FIG. 1, in order to couple each of the light emitting diodes 112 similar to the vertical type light emitting diode to the transparent electrode 116 of the support substrate 114, a bonding portion S may be formed between the p-type electrode 33 and the transparent electrode 116, and the wall 35 may be formed to prevent the bonding portion S from escaping from a space between the p-type electrode 33 and the transparent electrode 116.

The wall 35 may be formed to cover a portion of the p-type electrode 33 such that the p-type electrode 33 can be exposed on the p-type semiconductor layer 27, and may be composed of a plurality of layers, as shown in the drawings. The wall 35 may include a first layer and a second layer, and may be formed by forming the first layer including SiN on the p-type semiconductor layer 27 so as to cover a portion of the p-type electrode 33, followed by forming the second layer including SiO₂ on the first layer. The second layer may have a greater thickness and a smaller width than the first layer.

The support substrate 114 is a substrate on which the plurality of light emitting diodes 112 will be mounted, and may be an insulation substrate, a conductive substrate, or a circuit board. By way of example, the support substrate 114 may be a sapphire substrate, a gallium nitride substrate, a glass substrate, a silicon carbide substrate, a silicon substrate, a metal substrate, or a ceramic substrate. The support substrate 114 is formed on an upper surface thereof with the plurality of conductive patterns 35 to be electrically connected to the plurality of light emitting diodes 112 and may include a circuit pattern therein, as needed. The support substrate 114 may be a flexible substrate.

The transparent electrode 116 may be formed on the support substrate 114 and is electrically connected to the p-type electrode 33 of the light emitting diode 112. In this exemplary embodiment, a plurality of transparent electrodes 116 may be formed on the support substrate 114, and one light emitting diode 112 may be coupled to one transparent electrode 116, or the plurality of light emitting diodes 112 may be coupled to one transparent electrode 116, as needed. In addition, the plural transparent electrodes 116 may be separated from each other on the support substrate 114. By way of example, the transparent electrodes 116 may be formed of indium tin oxide (ITO) and the like.

The blocking part 118 is formed on the support substrate 114 and is provided in plural. The blocking part 118 allows light emitted from the light emitting diodes 112 to be emitted to the outside only through the transparent electrodes 116 and prevents light emitted from a certain light emitting diode from mixing with light emitted from adjacent light emitting diodes 112. Accordingly, the blocking part 118 may be formed between the transparent electrodes 116 separated from each other and may be formed to cover a portion of each of the transparent electrodes 116, as needed. In this exemplary embodiment, the blocking part 118 is formed of chromium (Cr).

The insulation layer 120 surrounds each of the light emitting diodes 112 and covers an exposed surface of a connecting plane between the light emitting diodes 112. With this structure, the insulation layer 120 may be formed to partially cover the blocking part 118. In the structure wherein the insulation layer 120 surrounds each of the light emitting diodes 112, the n-type semiconductor layer 23 and the n-type electrode 31 of each of the light emitting diodes 112 are exposed through the insulation layer 120.

The first connection electrodes 122 cover the insulation layer 120 and also covers the n-type semiconductor layer 23 and the n-type electrode 31 not covered by the insulation layer 120. Accordingly, the first connection electrodes 122 may be electrically connected to the n-type semiconductor layer 23.

The TFT panel unit 130 includes a panel substrate 132 and second connection electrodes 134 and is coupled to the light emitting diode part 110 to supply power to the light emitting diode part 110. The TFT panel unit 130 controls power supplied to the light emitting diode part 110 to allow only some of the light emitting diodes 112 in the light emitting diode part 110 to emit light.

The panel substrate 132 has a TFT drive circuit therein. The TFT drive circuit is a circuit for driving an active matrix (AM).

The second connection electrode 134 is electrically connected to the TFT drive circuit of the panel substrate 132 and to the first connection electrode 122 of the light emitting diode part 110. In this structure, power supplied through the TFT drive circuit can be supplied to each of the light emitting diodes 112 through the first and second connection electrodes 122, 134. In this exemplary embodiment, the second connection electrode 134 may be covered by a separate protective layer, which may include SiNx.

The anisotropic conductive film 150 serves to electrically connect the light emitting diode part 110 to the TFT panel unit 130. The anisotropic conductive film 150 includes an adhesive organic insulation material and contains conductive particles uniformly dispersed therein to achieve electrical connection. The anisotropic conductive film 150 exhibits conductivity in the thickness direction thereof and insulation properties in the plane direction thereof. In addition, the anisotropic conductive film exhibits adhesive properties and can be used to bond the light emitting diode part 110 to the TFT panel such that the light emitting diode part 110 can be electrically connected to the TFT panel therethrough. Particularly, the anisotropic conductive film 150 can be advantageously used to connect ITO electrodes which are difficult to solder at high temperature.

As such, in the structure wherein the light emitting diode part 110 is coupled to the TFT panel via the anisotropic conductive film 150, the first connection electrode 122 of the light emitting diode part 110 is electrically connected to the second connection electrode 134 of the TFT panel unit 130, thereby forming an electrode connection portion 152.

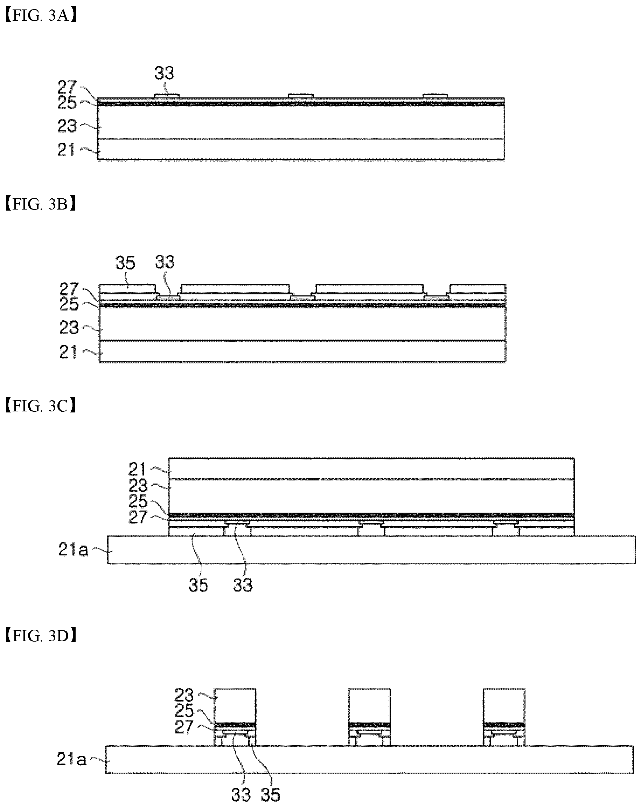

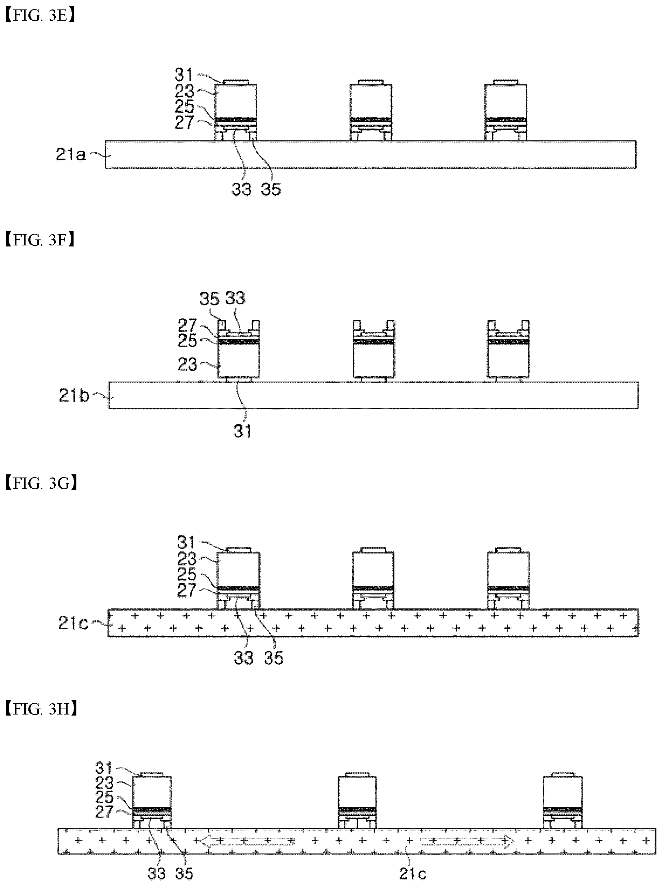

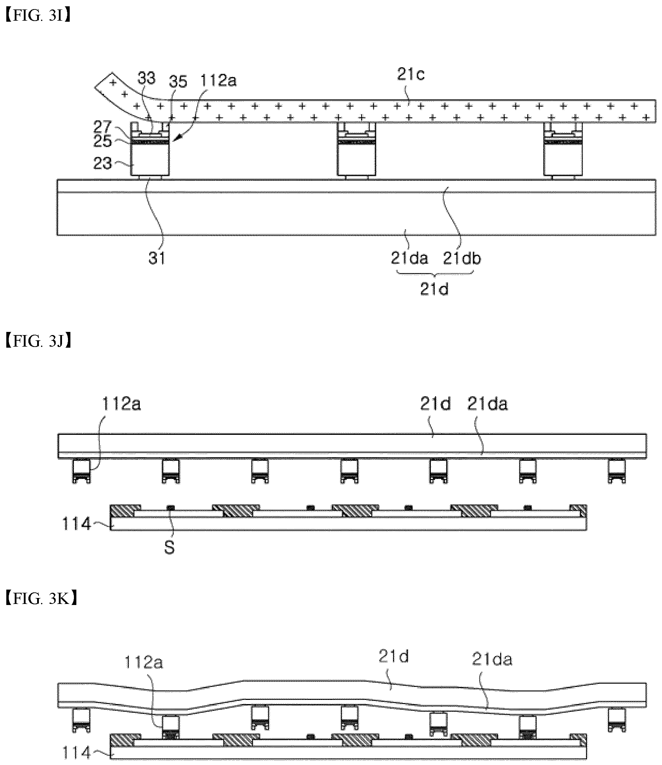

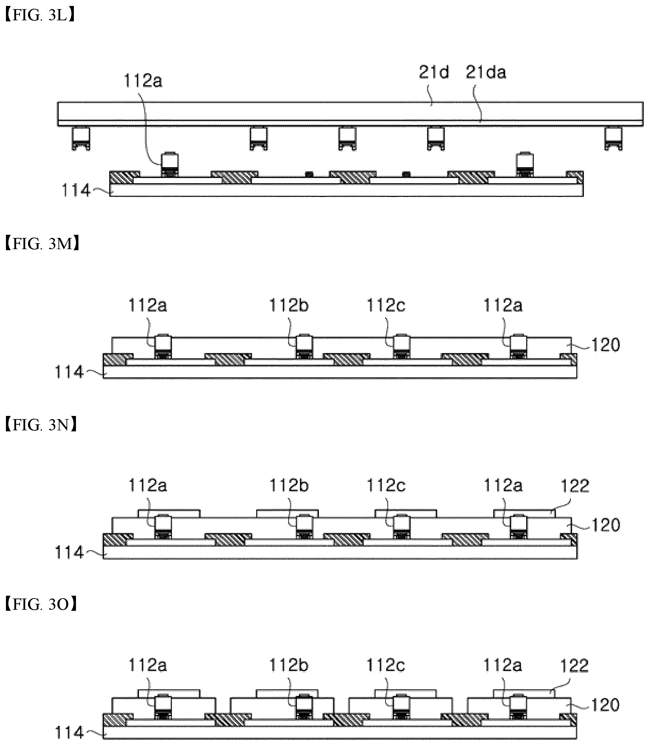

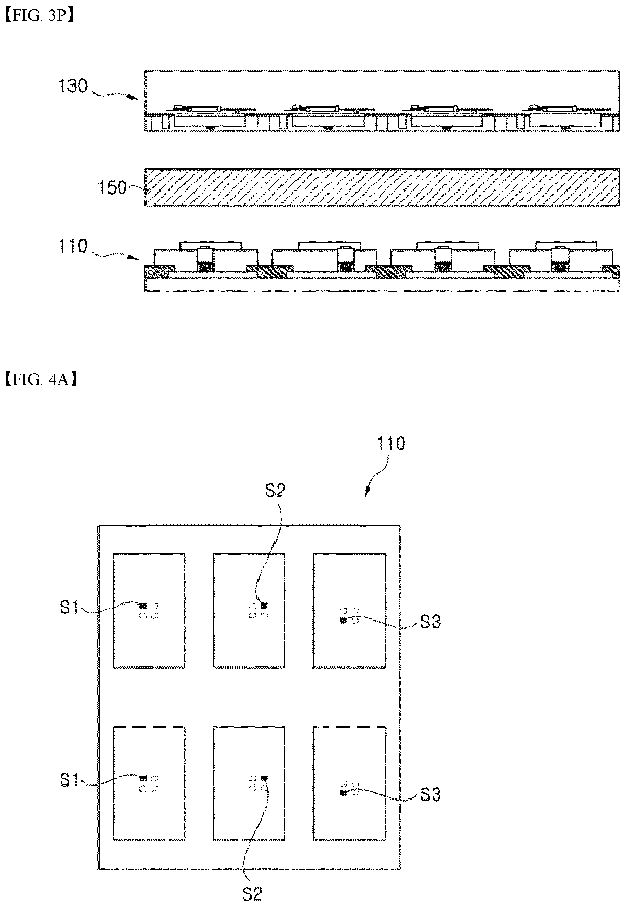

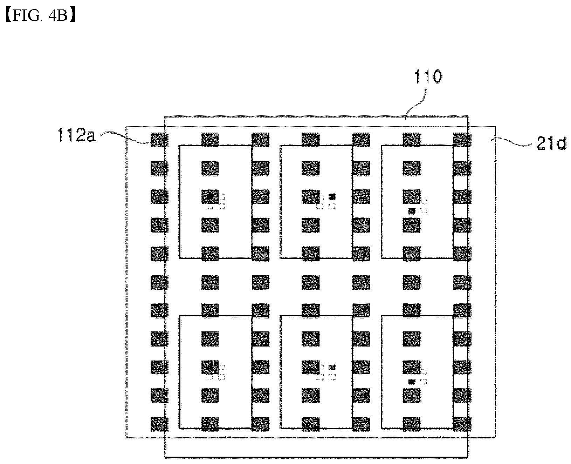

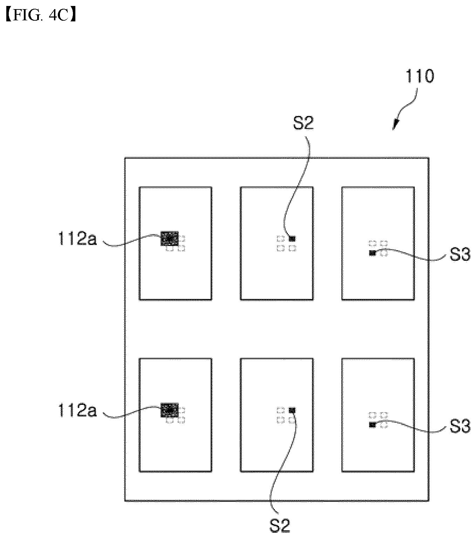

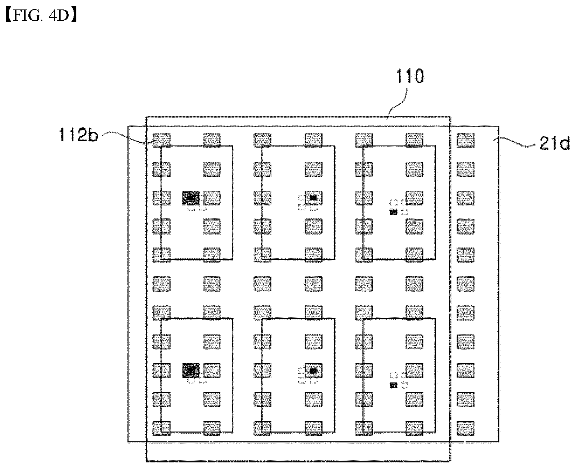

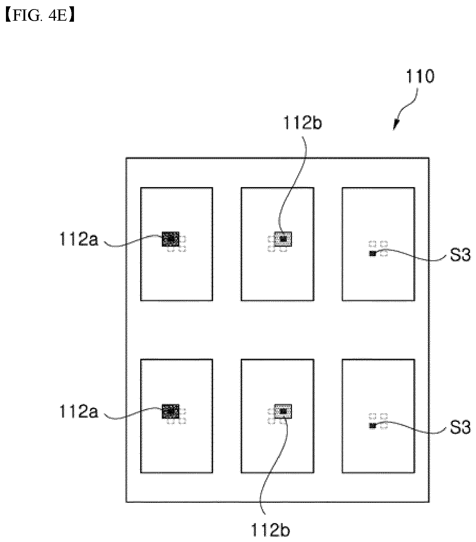

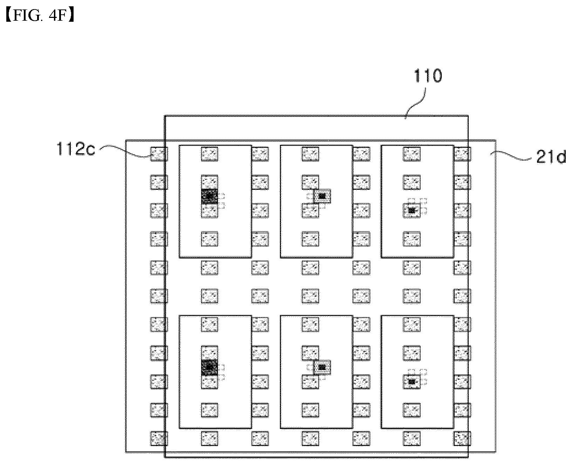

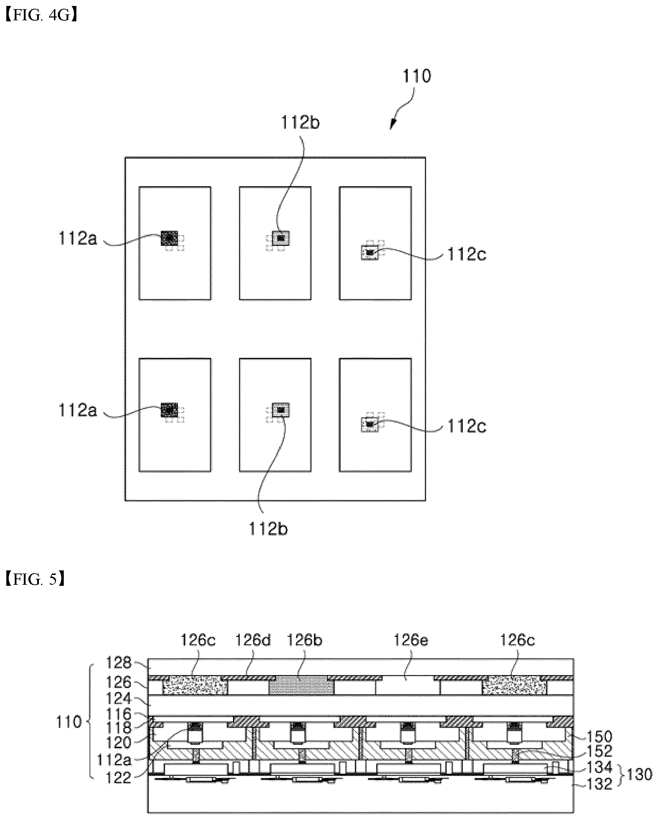

FIG. 3 and FIG. 4 are sectional views and plan views illustrating a process of forming the light emitting diode part 110 of the display apparatus 100 according to the first exemplary embodiment of the present disclosure, which is an embodiment of the invention.

The process of forming the light emitting diode part 110 according to this exemplary embodiment will be described with reference to FIG. 3 and FIG. 4. First, as shown in FIG. 3A, an n-type semiconductor layer 23, an active layer 25 and a p-type semiconductor layer 27 are sequentially grown on a growth substrate. Then, a p-type electrode 33 is formed on the p-type semiconductor layer 27. In this exemplary embodiment, a plurality of p-type electrodes 33 may be formed to be separated from each other by a predetermined distance such that one p-type electrode 33 is provided to one light emitting diode 112.

Referring to FIG. 3B, after forming the p-type electrodes 33, a wall 35 is formed on the p-type semiconductor layer 27. The wall 35 may be composed of first and second layers. The first layer includes SiN and is formed to cover the entirety of the p-type semiconductor layer 27 while covering a portion of each of the p-type electrodes 33. The second layer includes SiO₂ and is formed on the first layer. The second layer may have a greater thickness than the first layer and may be formed on a region of the first layer in which the p-type electrode 33 is not formed.

Referring to FIG. 3C, after the wall 35 is formed on the p-type semiconductor layer 27, the grown semiconductor layers are coupled to a first substrate. In this process, the second layer of the wall 35 is coupled to the first substrate. The first substrate may be the same as the support substrate 114 and may be a sapphire substrate in this exemplary embodiment.

Referring to FIG. 3D, with the semiconductor layers coupled to the first substrate, the growth substrate may be removed from the semiconductor layers by LLO and the semiconductor layers may be divided into individual light emitting diodes 112 by etching. Here, division of the semiconductor layers into individual light emitting diodes 112 may be performed by dry etching.

Referring to FIG. 3E, after the semiconductor layers are divided into the individual light emitting diodes 112, n-type electrodes 31 may be formed on the n-type semiconductor layer 23. Alternatively, the n-type electrodes 31 may be formed before division of the semiconductor layers into the individual light emitting diodes 112. Then, as shown in FIG. 3F, the light emitting diodes 112 are coupled to a second substrate such that the n-type electrodes 31 can be coupled to the second substrate, followed by removing the first substrate. The second substrate may be the same kind of substrate as the first substrate.

Then, as shown in FIG. 3G, the light emitting diodes 112 are coupled to a third substrate such that the wall 35 can be coupled to the third substrate, followed by removing the second substrate. In this exemplary embodiment, the third substrate may be a stretchable substrate that is stretchable in the plane direction thereof. Thus, as shown in FIG. 3H, the stretchable third substrate is stretched to enlarge distances between the light emitting diodes 112.

With the distances between the light emitting diodes 112 enlarged, the light emitting diodes 112 are coupled to a fourth substrate such that the n-type electrodes 31 can be coupled to the fourth substrate, as shown in FIG. 3I. As a result, the distances between the light emitting diodes 112 can be maintained by the stretchable third substrate. In this exemplary embodiment, the fourth substrate may include a flexible base and a bonding layer formed on the base.

Then, referring to FIG. 3J, the plurality of light emitting diodes 112 arranged on the fourth substrate is bonded to the support substrate 114, which may be formed with a bonding portion S at a location corresponding to each of the light emitting diodes 112. With the transparent electrodes 116 and the blocking part 118 formed on the support substrate 114, the bonding portion S is formed at a mounting location of each of the light emitting diodes 112 on the support substrate 114. Accordingly, even when the entire plural light emitting diodes coupled to the fourth substrate are transferred to an upper surface of the support substrate 114, the light emitting diodes 112 can be transferred only to locations of the support substrate 114 at which the bonding portions S are formed.

Referring to FIG. 3K, external force may be applied only to the light emitting diodes 112 disposed corresponding to the locations of the bonding portions S on the support substrate 114 among the light emitting diodes 112 coupled to the fourth substrate, such that only the light emitting diodes 112 disposed corresponding to the bonding portions S can be bonded to the support substrate 114. As a result, as shown in FIG. 3L, the light emitting diodes 112 can be coupled to the support substrate at the locations of the bonding portions S thereon.

Although not shown in the drawings, in the case where only some light emitting diodes 112 are selectively coupled to the support substrate 114 by applying external force only to target light emitting diodes among the plurality of light emitting diodes 112 arranged on the fourth substrate as shown in FIG. 3K, the stretchable third substrate may be omitted. That is, only some light emitting diodes 112 may be coupled to the support substrate 114 by selectively applying external force only to target light emitting diodes to be coupled to the support substrate 114 using a flexible fourth substrate instead of the second substrate shown in FIG. 3F.

In this exemplary embodiment, with regard to mounting the light emitting diodes 112 on the support substrate 114 as shown in FIG. 3L, the following description will be given of mounting blue light emitting diodes 112a, green light emitting diodes 112b and red light emitting diodes 112c on the support substrate 114 with reference to FIG. 4. Here, the processes of manufacturing each of the blue light emitting diodes 112a, the green light emitting diodes 112b and the red light emitting diodes 112c are the same those shown in FIG. 3A to FIG. 3I.

Like FIG. 3J, FIG. 4A shows the bonding portions S formed on the support substrate 114, in which the bonding portions S are formed at all locations on the support substrate 114 at which the blue light emitting diodes 112a, the green light emitting diodes 112b and the red light emitting diodes 112c are coupled, respectively. The bonding portions S may be classified into first to third bonding portions S1, S2, S3. The first bonding portion S1 is formed to bond the blue light emitting diodes 112a to the support substrate and the second bonding portion S2 is formed to bond the green light emitting diodes 112b thereto. The third bonding portion S3 is formed to bond the red light emitting diodes 112c thereto.

The first to third bonding portions S1, S2, S3 may have different bonding temperatures. Specifically, the first bonding portion S1 has the highest bonding temperature and the third bonding portion S3 has the lowest bonding temperature. For example, the first bonding portion S1 is formed of AgSn and has a bonding temperature of about 230°C and the second bonding portion S2 is formed of ZnSn and has a bonding temperature of about 198°C. The third bonding portion S3 is formed of In and has a bonding temperature of about 157°C. The bonding temperatures of the first to third bonding portions S1, S2, S3 are differently set due to different bonding sequences of the light emitting diodes 112 to the respective bonding portions S.

Since the blue light emitting diodes 112a are first bonded to the support substrate 114, the first bonding portion S1 has the highest bonding temperature. Thus, since the first bonding portion S1 has a higher bonding temperature than the second bonding portion S2 or the third bonding portion S3, the first bonding portion S1 can maintain a bonded state of the blue light emitting diodes 112a during bonding of the green light emitting diodes 112b or the red light emitting diodes 112c.

After the first to third bonding portions S1, S2, S3 are formed on the support substrate 114 as shown in FIG. 4A, the fourth substrate on which the blue light emitting diodes 112a are formed is placed at a corresponding location on the support substrate 114, and the blue light emitting diodes 112a are coupled to the support substrate 114, as shown in FIG. 4B. Here, the distances between the blue light emitting diodes 112a formed on the fourth substrate are widened by the stretchable substrate, which is provided as the third substrate, as compared with the distances between the blue light emitting diodes 112a formed on the growth substrate. Accordingly, each of the blue light emitting diodes 112a is not disposed at a location corresponding to the second bonding portion S2 or the third bonding portion S3. Then, with the blue light emitting diodes 112a contacting the first bonding portion S1, the first bonding portion S1 is heated to about 230°C and cooled to bond the blue light emitting diodes 112a to the support substrate 114 via the first bonding portion S1.

FIG. 4C shows the blue light emitting diodes 112a bonded to the support substrate 114. Thereafter, the fourth substrate on which the green light emitting diodes 112b are formed is placed at a corresponding location on the support substrate 114, and the green light emitting diodes 112b are bonded to the support substrate 114, as shown in FIG. 4D. Here, the distances between the green light emitting diodes 112b formed on the fourth substrate are greater than the distances between the green light emitting diodes 112b formed on the growth substrate, as described above. Accordingly, there is no interference between the blue light emitting diode 112a and the green light emitting diode 112b placed at locations corresponding to the second bonding portion S2 formed on the support substrate 114. Then, with the green light emitting diodes 112b contacting the second bonding portion S2, the second bonding portion S2 is heated to about 198°C and cooled to bond the green light emitting diodes 112b to the support substrate 114 via the second bonding portion S2. In this way, the green light emitting diodes 112b can be bonded to the support substrate 114.

FIG. 4E shows the blue light emitting diodes 112a and the green light emitting diodes 112b bonded to the support substrate 114. Thereafter, the fourth substrate on which the red light emitting diodes 112c are formed is placed at a corresponding location on the support substrate 114, and the red light emitting diodes 112c are bonded to the support substrate 114, as shown in FIG. 4F. Here, the distances between the red light emitting diodes 112c formed on the fourth substrate are greater than the distances between the red light emitting diodes 112c formed on the growth substrate, as described above, thereby preventing interference with the blue light emitting diodes 112a or the green light emitting diodes 112b disposed on the support substrate 114. Then, with the red light emitting diodes 112c contacting the third bonding portion S3, the third bonding portion S3 are heated to about 157°C and cooled to bond the red light emitting diodes 112c to the support substrate 114 via the third bonding portion S3. In this way, the green light emitting diodes 112b can be bonded to the support substrate 114. FIG. 4G shows the blue light emitting diode 112a, the green light emitting diode 112b and the red light emitting diode 112c bonded to the support substrate 114.

In this exemplary embodiment, separation distances between the blue light emitting diode 112a, the green light emitting diode 112b and the red light emitting diode 112c formed on the different fourth substrates may be at least twice the width of each of the light emitting diodes 112. In this way, with the distances between the light emitting diodes maintained at at least twice the width of each of the light emitting diodes on the support substrate 114, the light emitting diodes 112 are bonded to the support substrate 114, thereby preventing interference between the other light emitting diodes 112.

FIG. 3M is a sectional view corresponding to the plan view shown in FIG. 4G. That is, referring to FIG. 3M, each of the blue light emitting diodes 112a, the green light emitting diodes 112b and the red light emitting diodes 112c is bonded to the support substrate 114. In this state, an insulation layer 120 may be formed to cover the entirety of each of the light emitting diodes 112 excluding a portion thereof, as shown in FIG. 3N. The insulation layer 120 is formed to cover both the transparent electrodes 116 and the blocking part 118 while surrounding each of the light emitting diodes 112. With this structure, the insulation layer 120 can prevent the transparent electrode 116 electrically connected to each of the light emitting diodes 112 from being exposed to the outside. An upper surface of the n-type semiconductor layer 23 and the n-type electrode 31 of each of the light emitting diodes 112 can be exposed through an upper surface of the insulation layer 120.

With the n-type semiconductor layer 23 and the n-type electrode 31 exposed through the upper surface of the insulation layer 120, first connection electrodes 122 may be formed on the upper surface of the insulation layer 120 to cover the n-type semiconductor layer 23 and the n-type electrodes 31, as shown in FIG. 3O. As a result, the light emitting diode part 110 according to this exemplary embodiment can be formed.

Thereafter, the light emitting diode part 110 is bonded to the TFT panel unit 130 via an anisotropic connection film, as shown in FIG. 3P, thereby providing the display apparatus 100 according to the first exemplary embodiment, as shown in FIG. 1.

FIG. 5 is a sectional view of a display apparatus according to a second exemplary embodiment of the present disclosure, which is an embodiment of the invention.

Referring to FIG. 5, a display apparatus 100 according to the second exemplary embodiment of the present disclosure includes a light emitting diode part 110, a TFT panel unit 130, and an anisotropic conductive film 150. Description of the same components as those of the first exemplary embodiment will be omitted.

The light emitting diode part 110 includes light emitting diodes 112, transparent electrodes 116, a blocking part 118, an insulation layer 120, first connection electrodes 122, a transparent substrate 124, a phosphor layer 126, and a protective substrate 128.

The light emitting diode part 110 includes a plurality of light emitting diodes 112, and blue light emitting diodes 112a emitting blue light may be used as the light emitting diodes 112. The blue light emitting diodes 112a are electrically connected to the transparent electrodes 116 and the blocking part 118 may be formed between the transparent electrodes 116. In addition, the transparent substrate 124 may be formed on the transparent electrode 116. The transparent substrate 124 may serve as the support substrate 114 of the display apparatus 100 according to the first exemplary embodiment. Alternatively, as in the first exemplary embodiment, after forming the light emitting diode part 110 using the support substrate 114, the support substrate 114 may be removed therefrom and the transparent substrate 124 may be formed again.

The phosphor layer 126 may be formed on an upper surface of the transparent substrate 124. The phosphor layer 126 may be formed on the blue light emitting diodes 112a such that one of a green phosphor layer 126b, a red phosphor layer 126c and a transparent layer 126e is formed thereon. In addition, a blocking layer 126d may be formed between the green phosphor layer 126b, the red phosphor layer 126c and the transparent layer 126e. The green phosphor layer 126b converts wavelengths of light emitted from the blue light emitting diode 112a such that green light can be emitted from the green phosphor layer 126b, and the red phosphor layer 126c converts wavelengths of light emitted from the blue light emitting diode 112a such that red light can be emitted from the red phosphor layer 126c. The transparent layer 126e is placed near the green phosphor layer 126b and the red phosphor layer 126c to allow blue light emitted from the blue light emitting diode 112a to pass therethrough. Accordingly, red light, green light and blue light can be emitted through the phosphor layer 126.

The protective substrate 128 may be formed on an upper surface of the phosphor layer 126. The protective substrate 128 can prevent the phosphor layer 126 from being exposed to the outside and may be formed of a transparent material as in the transparent substrate 124.

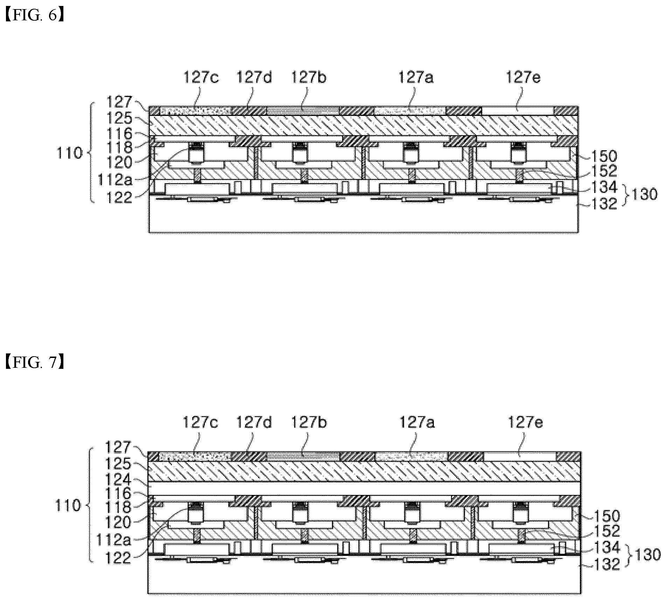

FIG. 6 is a sectional view of a display apparatus according to a third exemplary embodiment of the present disclosure, which is an embodiment of the invention.

Referring to FIG. 6, a display apparatus 100 according to the third exemplary embodiment includes a light emitting diode part 110, a TFT panel unit 130, and an anisotropic conductive film 150. Description of the same components as those of the first exemplary embodiment will be omitted.

The light emitting diode part 110 includes light emitting diodes 112, transparent electrodes 116, a blocking part 118, a white phosphor film 125, and a color film.

The light emitting diode part 110 includes a plurality of light emitting diodes 112, and blue light emitting diodes 112a are used as in the second exemplary embodiment. The blue light emitting diodes 112a are electrically connected to the transparent electrodes 116 and the blocking part 118 may be formed between the transparent electrodes 116. The white phosphor film 125 may be formed on an upper surface of the transparent electrode 116.

The white phosphor film 125 converts blue light emitted from the blue light emitting diode 112a into white light. To this end, the white phosphor film 125 may include a green phosphor and a red phosphor.

The color filter 127 may be formed on an upper surface of the white phosphor film 125. The color filter 127 may be formed in a film shape and filters white light emitted from the white phosphor film 125 excluding one of blue light, green light and red light of the white light. The color filter 127 may include a blue light portion 127a that filters white light to allow blue light to pass therethrough, a green light portion 127b that filters white light to allow green light to pass therethrough, and a red light portion 127c that filters white light to allow red light to pass therethrough. The color filter 127 may further include a transparent portion 127e to allow white light to pass therethrough without wavelength conversion.

The blue light portion 127a, the green light portion 127b, the red light portion 127c and the transparent portion 127e may be disposed adjacent one another. Alternatively, a light blocking portion 127d may be formed between the blue light portion 127a, the green light portion 127b, the red light portion 127c and the transparent portion 127e.

FIG. 7 is a sectional view of a display apparatus according to a fourth exemplary embodiment of the present disclosure, which is an embodiment of the invention.

Referring to FIG. 7, a display apparatus 100 according to the fourth exemplary embodiment includes a light emitting diode part 110, a TFT panel unit 130, and an anisotropic conductive film 150. Description of the same components as those of the first and third exemplary embodiments will be omitted.

The light emitting diode part 110 includes light emitting diodes 112, transparent electrodes 116, a blocking part 118, a transparent substrate 124, a white phosphor film 125, and a color film.

The light emitting diode part 110 includes a plurality of light emitting diodes 112, and blue light emitting diodes 112a are used as in the second exemplary embodiment. The blue light emitting diodes 112a are electrically connected to the transparent electrodes 116 and the blocking part 118 may be formed between the transparent electrodes 116. The transparent substrate 124 may be formed on an upper surface of the transparent electrode 116.

The transparent substrate 124 may serve as the support substrate 114 of the display apparatus 100 according to the first exemplary embodiment. Alternatively, as in the first exemplary embodiment, after forming the light emitting diode part 110 using the support substrate 114, the support substrate 114 may be removed therefrom and the transparent substrate 124 may be formed again.

The white phosphor film 125 may be formed on an upper surface of the transparent electrode 116 and the color filter 127 may be formed on an upper surface of the white phosphor film 125. The white phosphor film 125 and the color filter 127 are the same as those of the display apparatus according to the third exemplary embodiment and detailed descriptions thereof will be omitted.

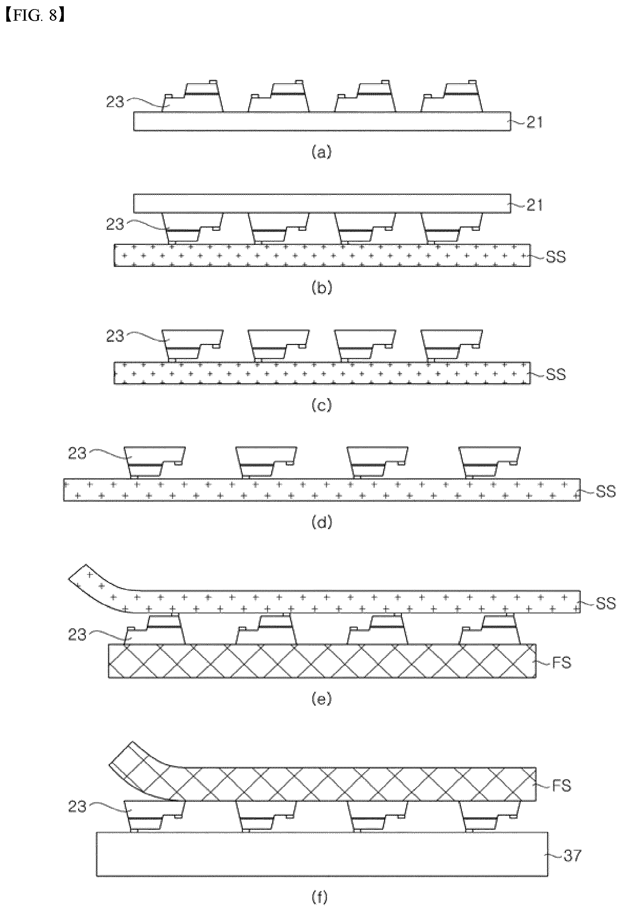

FIG. 8 shows sectional views of a display apparatus according to a fifth exemplary embodiment of the present disclosure. FIG. 8(a) to FIG. 8(f) are sectional views illustrating a process of manufacturing the display apparatus according to the fifth exemplary embodiment, in which a plurality of light emitting structures grown on a growth substrate is coupled to a support substrate after adjustment of separation distances between the light emitting structures using a stretchable sheet SS.

The display apparatus according to the fifth exemplary embodiment includes light emitting structures 23, n-type bumps 31, p-type bumps 33, a support substrate 37, and a wavelength conversion part 43. Description of the same components as those of the above exemplary embodiments will be omitted. The following description will focus on a process of coupling light emitting structures 23 grown on the growth substrate 21 to the support substrate 37 with reference to FIG. 8.

The light emitting structure 23 may include a partially exposed region of the n-type semiconductor layer 25, which is formed by partially removing the p-type semiconductor layer 29 and the active layer 27. An n-type electrode pad may be placed on the exposed region of the n-type semiconductor layer 25 and a p-type electrode pad may be placed on the p-type semiconductor layer 29.

Although the light emitting structure 23 uses a flip-chip type light emitting diode in this exemplary embodiment, it should be understood that a vertical type light emitting diode or a lateral type light emitting diode may also be used.

The growth substrate 21 may be selected from among any substrates allowing growth of nitride semiconductor layers thereon and may be an insulation or conductive substrate. By way of example, the growth substrate 21 may be a sapphire substrate, a silicon substrate, a silicon carbide substrate, an aluminum nitride substrate, or a gallium nitride substrate. In this exemplary embodiment, the growth substrate 21 may be a sapphire substrate and may include a C-plane as a growth plane on which nitride semiconductor layers are grown.

As shown in FIG. 8(a), the plurality of light emitting structures 23 is grown on the growth substrate 21. In this exemplary embodiment, the plural light emitting structures 23 are arranged in a predetermined pattern on the growth substrate 21 and are separated from each other during growth.

With the growth substrate 21 turned upside down, the light emitting structures 23 grown on the growth substrate 21 are coupled to an upper surface of the stretchable sheet, as shown in FIG. 8(b). In addition, after the plurality of light emitting structures 23 is coupled to the stretchable sheet (SS), the growth substrate 21 is removed from the light emitting structures by LLO and the like, as shown in FIG. 8(c).

Thereafter, as shown in FIG. 8(d), since the stretchable sheet (SS) can be two-dimensionally stretched or compressed, the separation distances between the light emitting structures 23 can be adjusted by stretching or compressing the stretchable sheet (SS). FIG. 8(d) shows one example in which the separation distances between the light emitting structures 23 are enlarged by stretching the stretchable sheet (SS). In one embodiment, the stretchable sheet (SS) may be a blue sheet.

In this way, the stretchable sheet (SS) is turned upside down in a stretched state and coupled to a fixing sheet (FS) via the light emitting structures 23 such that the light emitting structures 23 are coupled to the fixing sheet. This state is shown in FIG. 8(e), and after the plurality of light emitting structures 23 is coupled to the fixing sheet (FS), the stretchable sheet (SS) is removed from the upper surfaces of the plurality of light emitting structures 23. In this exemplary embodiment, since the stretchable sheet (SS) can be uniformly stretchable in two dimensions, the distances between the plural light emitting structures 23 can be uniformly widened. The distances between the plural light emitting structures 23 can be adjusted in various ways as needed. The fixing sheet (FS) serves to fix the locations of the light emitting structure 23 in order to maintain the distances between the plural light emitting structures 23 adjusted by the stretchable sheet (SS).

After each of the light emitting structures 23 is coupled to the fixing sheet (FS), the plurality of light emitting structures 23 is coupled to the support substrate 37 and the fixing sheet (FS) is removed from the light emitting structures, as shown in FIG. 8(f). In this exemplary embodiment, the support substrate 37 includes conductive patterns 35 or interconnection circuits, and may be a general PCB, a flexible substrate, or a stretchable substrate like the stretchable sheet (SS).

As described above, since the separation distances between the plural light emitting structures 23 may be adjusted using the stretchable sheet (SS), the light emitting structures 23 may be simultaneously transferred to the support substrate after uniformly increasing the distances therebetween. Accordingly, the plurality of light emitting structures 23 used in the display apparatus according to the present disclosure may also be used not only in a small wearable apparatus, but also in a large display.

The invention is defined by the appended claims.

**< Legend of Reference Numerals>**

| | | | |
|---|---|---|---|
| 100: | display apparatus | | |
| 110: | light emitting diode part | 112: | light emitting diode |
| 112a: | blue light emitting diode | 112b: | green light emitting diode |
| 112c: | red light emitting diode | | |
| 23: | n-type semiconductor layer | 25: | active layer |
| 27: | p-type semiconductor layer | 31: | n-type electrode |
| 33: | p-type electrode | 35: | wall |
| 114: | support substrate | 116: | transparent electrode |
| 118: | blocking portion | 120: | insulation layer |
| 122: | first connection electrode | 124: | transparent substrate |
| 125: | white phosphor film | 126: | phosphor layer |
| 126b: | green phosphor layer | 126c: | red phosphor layer |
| 126d: | blocking layer | 126e: | transparent layer |
| 127: | color filter | 127a: | blue light portion |
| 127b: | green light portion | 127c: | red light portion |
| 127d: | light blocking portion | 127e: | transparent portion |
| 128: | protective substrate | 130: | TFT panel unit |
| 132: | panel substrate | 134: | second connection electrode |
| 150: | anisotropic conductive film | 152: | electrode connection portion |
| 200: | backlight unit | 260: | first driver |
| 300: | TFT-LCD panel unit | 310: | second driver |
| P: | pixel | | |
| S: | bonding portion | S1: | first bonding portion |
| S2: | second bonding portion | S3: | third bonding portion |

## Claims

1. A display device comprising:
a light emitting diode part (110) having a plurality of sub-pixels, a thin film transistor (TFT) panel unit (130),
and an anisotropic conductive film (150),
wherein
the light emitting diode part (110) includes a plurality of light emitting diodes (112), a support substrate (114), transparent electrodes (116), a blocking part (118), an insulation layer (120), and first connection electrodes (122),
wherein the plurality of light emitting diodes (112) is regularly arranged on the support substrate (114),
wherein the plurality of light emitting diodes (112) includes a plurality of blue light emitting diodes (112a) configured to emit blue light, a plurality of green light emitting diodes (112b) configured to emit green light, and a plurality of red light emitting diodes (112c) configured to emit red light being alternately arranged such that the blue light emitters (112a), the green light emitters (112b) and the red light emitters (112c) are adjacent to one another,wherein each of the light emitting diodes (112) includes an n-type semiconductor layer (23), a p-type semiconductor layer (27), an active layer (25) disposed between the n-type semiconductor layer (23) and the p-type semiconductor layer (27), an n-type electrode (31) formed on an outer surface of the n-type semiconductor layer, and a p-type electrode (33) formed on an outer surface of the p-type semiconductor layer,
wherein the transparent electrodes (116) are electrically connected to the p-type electrodes,
wherein the blocking part (118) is formed on the support substrate (114) and is provided in plural and is configured to allow light emitted from the light emitting diodes (112) to be emitted to the outside only through the transparent electrodes (116) and to prevent light emitted from a certain light emitting diode from mixing with light emitted from adjacent light emitting diodes (112),
wherein the insulation layer (120) surrounds each of the light emitting diodes (112) and
covers an exposed surface of a connecting plane between the light emitting diodes (112),
wherein the n-type electrode (31) and the n-type semiconductor layer (23) of each of the light emitting diodes (112) is exposed through the insulation layer (120), and
wherein the first connection electrode (122) covers the insulation layer (120) and also covers the n-type semiconductor layer (23) and the n-type electrode (31) not covered by the insulation layer (120) and is electrically connected to the n-type semiconductor layer (23),
wherein a region including a single light emitting diode (112) is configured to be used as a sub-pixel in the display device,
wherein the TFT panel unit (130) includes a panel substrate (132) and second connection electrodes (134) and is coupled to the light emitting diode part (110) and is configured to supply power to the light emitting diode part (110),
wherein the TFT panel unit (130) is configured to control power supplied to the light emitting diode part (110) to allow only some of the light emitting diodes (112) in the light emitting diode part (110) to emit light,
wherein the panel substrate (132) has a TFT drive circuit therein, wherein the TFT drive circuit is a circuit for driving an active matrix (AM),
wherein the second connection electrodes (134) are electrically connected to the TFT drive circuit of the panel substrate (132) and to the first connection electrodes (122) of the light emitting diode part (110),
wherein the anisotropic conductive film (150) serves to electrically connect the light emitting diode part (110) to the TFT panel unit (130), includes an adhesive organic insulation material and contains conductive particles uniformly dispersed therein to achieve electrical connection, and the anisotropic conductive film (150) is configured to exhibit conductivity in the thickness direction thereof and insulation properties in the plane direction thereof.

2. The display device of claim 1, wherein the sub-pixel has a larger size that the light emitting diode (112).

3. The display device of claim 1, wherein the second connection electrode (134) is covered by a separate protective layer.

4. The display device of claim 3, wherein the separate protective layer includes SiNₓ.

5. The display device of claim 1, wherein the display device is applied to a wearable apparatus.

## Patentansprüche

1. Anzeigevorrichtung, umfassend:
einen lichtemittierenden Abschnitt (110) mit einer Vielzahl von Subpixeln, eine thin film transistor (TFT) -Paneeleinheit (130) und eine anisotrope leitfähige Schicht (150),
wobei
der lichtemittierende Abschnitt (110) eine Vielzahl von lichtemittierenden Dioden (112), ein Trägersubstrat (114), transparente Elektroden (116), einen Sperrabschnitt (118), eine Isolierschicht (120) und erste Anschlusselektroden (122) umfasst,
wobei die Vielzahl von lichtemittierenden Dioden (112) regelmäßig auf dem Trägersubstrat (114) angeordnet ist,
wobei die Vielzahl von lichtemittierenden Dioden (112) eine Vielzahl von blauen lichtemittierenden Dioden (112a), die so ausgelegt sind, dass sie blaues Licht emittieren, eine Vielzahl von grünen lichtemittierenden Dioden (112b), die so ausgelegt sind, dass sie grünes Licht emittieren, und eine Vielzahl von roten lichtemittierenden Dioden (112c), die so ausgelegt sind, dass sie rotes Licht emittieren, abwechselnd so angeordnet sind, dass die blauen lichtemittierenden Dioden (112a), die grünen lichtemittierenden Dioden (112b) und die roten lichtemittierenden Dioden (112c) nebeneinander liegen, wobei jede der lichtemittierenden Dioden (112) eine n-Typ-Halbleiterschicht (23), eine p-Typ-Halbleiterschicht (27), eine aktive Schicht (25), die zwischen der n-Typ-Halbleiterschicht (23) und der p-Typ-Halbleiterschicht (27) angeordnet ist, eine n-Typ-Elektrode (31), die sich auf einer Außenfläche der n-Typ-Halbleiterschicht befindet, und eine p-Typ-Elektrode (33), die sich auf einer Außenfläche der p-Typ-Halbleiterschicht befindet,
wobei die transparenten Elektroden (116) elektrisch mit den p-Typ-Elektroden verbunden sind,
wobei der Sperrabschnitt (118) auf dem Trägersubstrat (114) ausgebildet ist, in mehrfacher Ausführung vorliegt und so konfiguriert ist, dass von den lichtemittierenden Dioden (112) emittiertes Licht nur durch die transparenten Elektroden (116) nach außen gelangen kann und verhindert wird, dass sich von einer bestimmten lichtemittierenden Diode emittiertes Licht mit dem von benachbarten lichtemittierenden Dioden (112) emittierten Licht vermischt,
wobei die Isolierschicht (120) jede der lichtemittierenden Dioden (112) umgibt und eine freiliegende Oberfläche einer Verbindungsebene zwischen den lichtemittierenden Dioden (112) bedeckt,
wobei die n-Typ-Elektrode (31) und die n-Typ-Halbleiterschicht (23) jeder der lichtemittierenden Dioden (112) durch die Isolierschicht (120) freigelegt sind, und
wobei die erste Anschlusselektrode (122) die Isolierschicht (120) bedeckt und zudem die n-Typ-Halbleiterschicht (23) sowie die n-Typ-Elektrode (31), die nicht von der Isolierschicht (120) bedeckt sind, bedeckt und elektrisch mit der n-Typ-Halbleiterschicht (23) verbunden ist,
wobei ein Bereich, der eine einzelne lichtemittierende Diode (112) umfasst, so konfiguriert ist, dass er als Subpixel in der Anzeigevorrichtung verwendet wird,
wobei die TFT-Paneeleinheit (130) ein Panel-Substrat (132) und zweite Anschlusselektroden (134) umfasst, mit dem lichtemittierenden Teil (110) gekoppelt ist und so ausgelegt ist, dass sie den lichtemittierenden Teil (110) mit Strom versorgt,
wobei die TFT-Paneeleinheit (130) so ausgelegt ist, dass sie die dem lichtemittierenden Teil (110) zugeführte Leistung so steuert, dass nur einige der lichtemittierenden Dioden (112) im lichtemittierenden Teil (110) Licht emittieren,
wobei das Panel-Substrat (132) eine darin angeordnete TFT-Ansteuerschaltung aufweist, wobei die TFT-Ansteuerschaltung eine Schaltung zum Ansteuern einer Aktivmatrix (AM) ist,
wobei die zweiten Anschlusselektroden (134) elektrisch mit der TFT-Ansteuerschaltung des Panelsubstrats (132) und mit den ersten Anschlusselektroden (122) des lichtemittierenden Teils (110) verbunden sind,
wobei der anisotrope leitfähige Film (150) dazu dient, den lichtemittierenden Abschnitt (110) elektrisch mit der TFT-Paneeleinheit (130) zu verbinden, einen organischen Klebstoff als Isoliermaterial umfasst und darin gleichmäßig dispergierte leitfähige Partikel enthält, um eine elektrische Verbindung herzustellen, und wobei der anisotrope leitfähige Film (150) so ausgebildet ist, dass er in seiner Dickenrichtung Leitfähigkeit und in seiner Ebenenrichtung Isolationseigenschaften aufweist.

2. Anzeigevorrichtung nach Anspruch 1, wobei das Subpixel eine größere Größe als die lichtemittierende Diode (112) aufweist.

3. Anzeigevorrichtung nach Anspruch 1, wobei die zweite Anschlusselektrode (134) von einer separaten Schutzschicht bedeckt ist.

4. Anzeigevorrichtung nach Anspruch 3, wobei die separate Schutzschicht SiNₓenthält.

5. Anzeigevorrichtung nach Anspruch 1, wobei die Anzeigevorrichtung in einer tragbaren Vorrichtung eingesetzt ist.

## Revendications

1. Dispositif d'affichage comprenant :
une partie à diodes électroluminescentes (110) comportant une pluralité de sous-pixels, une unité de panneau à thin film transistor (TFT) (130), et un film conducteur anisotrope (150),
dans lequel
la partie à diodes électroluminescentes (110) comprend une pluralité de diodes électroluminescentes (112), un substrat de support (114), des électrodes transparentes (116), une partie de blocage (118), une couche isolante (120) et des premières électrodes de connexion (122),
dans lequel la pluralité de diodes électroluminescentes (112) est disposée de manière régulière sur le substrat de support (114),
dans lequel la pluralité de diodes électroluminescentes (112) comprend une pluralité de diodes électroluminescentes bleues (112a) configurées pour émettre de la lumière bleue, une pluralité de diodes électroluminescentes vertes (112b) configurées pour émettre de la lumière verte, et une pluralité de diodes électroluminescentes rouges (112c) configurées pour émettre de la lumière rouge, disposées en alternance de telle sorte que les émetteurs de lumière bleue (112a), les émetteurs de lumière verte (112b) et les émetteurs de lumière rouge (112c) soient adjacents les uns aux autres, dans lequel chacune des diodes électroluminescentes (112) comprend une couche semi-conductrice de type n (23), une couche semi-conductrice de type p (27), une couche active (25) disposée entre la couche semi-conductrice de type n (23) et la couche semi-conductrice de type p (27), une électrode de type n (31) située sur une surface externe de la couche semi-conductrice de type n, et une électrode de type p (33) située sur une surface externe de la couche semi-conductrice de type p,
dans lequel les électrodes transparentes (116) sont reliées électriquement aux électrodes de type p,
dans lequel la partie de blocage (118) est formée sur le substrat de support (114), est prévue en plusieurs exemplaires et est configurée pour permettre à la lumière émise par les diodes électroluminescentes (112) de ne sortir vers l'extérieur qu'à travers les électrodes transparentes (116) et pour empêcher la lumière émise par une diode électroluminescente donnée de se mélanger à la lumière émise par les diodes électroluminescentes adjacentes (112),
dans lequel la couche isolante (120) entoure chacune des diodes électroluminescentes (112) et recouvre une surface exposée d'un plan de connexion entre les diodes électroluminescentes (112),
dans lequel l'électrode de type n (31) et la couche semi-conductrice de type n (23) de chacune des diodes électroluminescentes (112) sont exposées à travers la couche isolante (120), et
dans lequel la première électrode de connexion (122) recouvre la couche isolante (120) ainsi que la couche semi-conductrice de type n (23) et l'électrode de type n (31) non recouvertes par la couche isolante (120), et est connectée électriquement à la couche semi-conductrice de type n (23),
dans lequel une région comprenant une seule diode électroluminescente (112) est configurée pour être utilisée comme sous-pixel dans le dispositif d'affichage,
dans lequel l'unité de panneau TFT (130) comprend un substrat de panneau (132) et des deuxièmes électrodes de connexion (134), est couplée à la partie à diodes électroluminescentes (110) et est configurée pour alimenter en énergie la partie à diodes électroluminescentes (110), dans lequel l'unité de panneau TFT (130) est configurée pour effectuer le contrôle de l'alimentation fournie à la partie à diodes électroluminescentes (110) afin de permettre uniquement à certaines des diodes électroluminescentes (112) de la partie à diodes électroluminescentes (110) d'émettre de la lumière,
dans lequel le substrat de panneau (132) comporte un circuit de commande TFT, ledit circuit de commande TFT étant un circuit destiné à commander une matrice active (AM),
dans lequel les deuxièmes électrodes de connexion (134) sont reliées électriquement au circuit de commande TFT du substrat de panneau (132) et aux premières électrodes de connexion (122) de la partie à diodes électroluminescentes (110),
dans lequel le film conducteur anisotrope (150) sert à relier électriquement la partie à diodes électroluminescentes (110) à l'unité de panneau TFT (130), comprend un matériau isolant organique adhésif et contient des particules conductrices dispersées uniformément dans celui-ci pour réaliser la connexion électrique, et le film conducteur anisotrope (150) est configuré pour présenter une conductivité dans le sens de son épaisseur et des propriétés isolantes dans le sens de son plan.

2. Dispositif d'affichage selon la revendication 1, dans lequel le sous-pixel a une taille supérieure à celle de la diode électroluminescente (112).

3. Dispositif d'affichage selon la revendication 1, dans lequel la deuxième électrode de connexion (134) est recouverte d'une couche protectrice distincte.

4. Dispositif d'affichage selon la revendication 3, dans lequel la couche protectrice distincte comprend du SiNₓ.

5. Dispositif d'affichage selon la revendication 1, dans lequel le dispositif d'affichage est appliqué à un appareil portable.
